# EUROPÄISCHE PATENTSCHRIFT

(11) **EP 3 066 700 B1**
(45) Veröffentlichungstag und Bekanntmachung des Hinweises auf die Patenterteilung: **03.10.2018**
(21) Anmeldenummer: 14758833.9
(22) Anmeldetag: 27.08.2014
(51) Int. Cl.: H01L 41/04, H05H 1/24, H01L 41/107

(54) **PIEZOELEKTRISCHER TRANSFORMATOR UND GEGENELEKTRODE**
PIEZOELECTRIC TRANSFORMER AND COUNTER ELECTRODE
TRANSFORMATEUR PIEZOÉLECTRIQUE ET CONTRE-ÉLECTRODE

(30) Priorität: 08.11.2013 DE 102013112316
(43) Veröffentlichungstag der Anmeldung: 14.09.2016
(73) Patentinhaber: Epcos AG, 81671 München (DE)
(72) Erfinder: KRAXNER, Peter, A-8072 Fernitz (AT); PUFF, Markus, 8010 Graz (AT)
(74) Vertreter: Epping - Hermann - Fischer
(86) Internationale Anmeldenummer: PCT/EP2014/068172
(87) Internationale Veröffentlichungsnummer: WO 2015/067388

(56) Entgegenhaltungen:
- JP-A- 2007 107 491

## Beschreibung

Die vorliegende Erfindung betrifft einen piezoelektrischen Transformator und eine Vorrichtung mit einem piezoelektrischen Transformator sowie eine Gegenelektrode und eine Vorrichtung mit einer Gegenelektrode.

JP 2007/107491 A zeigt eine Verbrennungsmaschine mit einer Entladungselektrode und einer Gegenelektrode, wobei ein Dielektrikum bereitgestellt wird, dass zwischen den Elektroden angeordnet ist.

Eine zu lösende Aufgabe ist es, einen verbesserten piezoelektrischen Transformator und eine verbesserte Gegenelektrode für eine Vorrichtung zur Behandlung von Oberflächen anzugeben.

Diese Aufgabe wird durch einen piezoelektrischen Transformator mit den Merkmalen der Patentansprüche 1 und 16 gelöst. Vorteilhafte Ausgestaltungen und Weiterbildungen sind Gegenstand der abhängigen Patentansprüche.

Ein vorgeschlagener piezoelektrischer Transformator weist eine Oberflächenstruktur auf, die zumindest ein hervorstehendes Oberflächenstruktursegment aufweist. Der piezoelektrische Transformator weist weiterhin eine Kontur auf und ist geeignet, im Zusammenwirken mit einer Gegenelektrode zur Erzeugung eines Plasmas, ein Gas zu entladen. Die Oberflächenstruktur ist so ausgebildet, dass die Gasentladung an einer Vielzahl von Entladungsinitiationspunkten auf der Kontur einsetzt. Bei der Gasentladung kann es sich um eine dielektrische Barriereentladung oder eine andere Entladung handeln. Bei dem Plasma handelt es sich vorzugsweise um ein kaltes Plasma.

Die Kontur der Oberflächenstruktur bezeichnet vorzugsweise einen Umriss oder eine Einhüllende beziehungsweise einhüllende Linie oder Fläche der Oberflächenstruktur. Bei der Kontur handelt es sich vorzugsweise nicht um den tatsächlichen äußeren Umriss der Oberflächenstruktur, sondern um eine imaginäre, vorzugsweise ebene oder leicht gebogene Seitenlinie oder Seitenfläche. Vorzugsweise wird die Oberflächenstruktur von der Kontur umschlossen oder definiert, wobei Oberflächenpunkte oder Bereiche der Oberflächenstruktur direkt auf der Kontur oder innerhalb eines von der Kontur begrenzten oder umschlossenen Bereichs angeordnet sein können.

Die Gasentladung setzt vorzugsweise an einer Vielzahl von, beispielsweise diskreten, Entladungsinitiationspunkten auf der Kontur der Oberflächenstruktur ein. Die Entladungsinitiationspunkte bezeichnen vorzugsweise diejenigen Punkte auf der Kontur, in denen die Gasentladung zuerst oder energetisch am günstigsten initiiert werden kann.

Die Breite des Oberflächenstruktursegments der Oberflächenstruktur ist weiterhin vorzugsweise kleiner als die Breite des piezoelektrischen Transformators.

Die Breite des Oberflächenstruktursegments erstreckt sich vorzugsweise senkrecht zu einer Länge der Oberflächenstruktursegmente beziehungsweise der Oberflächenstruktur. Die Breite des piezoelektrischen Transformators erstreckt sich entsprechend vorzugsweise senkrecht zu einer Länge des piezoelektrischen Transformators. Die genannten Längen und Breiten können sich auf eine Aufsicht beziehungsweise einen Querschnitt der genannten Komponenten beziehen.

In einer bevorzugten Ausgestaltung ist die Oberflächenstruktur auf einer Ausgangsseite des piezoelektrischen Transformators angeordnet oder ausgebildet. Die Ausgangsseite bezeichnet vorzugsweise eine Seite des piezoelektrischen Transformators, an oder über die eine transformierte Ausgangsspannung abgegriffen werden kann.

Die Oberflächenstruktur beschreibt vorzugsweise keine einzige ebene Endfläche oder Ausgangsseite des piezoelektrischen Transformators, sondern weist beispielsweise eine Textur oder eine bestimmte, beispielsweise mikroskopisch strukturierte Oberfläche auf. Vorzugsweise umfasst die Oberflächenstruktur eine Vielzahl von hervorstehenden Oberflächenstruktursegmenten (siehe unten). Durch die Vorsehung der Oberflächenstruktur wird vorzugsweise erreicht, dass Oberflächenpunkte oder -bereiche des piezoelektrischen Transformators nicht alle samt in einer Ebene liegen, sondern der Abstand von einigen Oberflächenpunkten beispielsweise im Verhältnis zu einer Gegenelektrode des piezoelektrischen Transformators einen größeren Abstand aufweisen als andere Punkte. Dadurch kann mit Vorteil eine Vielzahl von Entladungsinitiationspunkten geschaffen werden, welche vorzugsweise der Gegenelektrode am nächsten angeordnet sind. Durch den geringeren Abstand wird in einer Vielzahl von Punkten auf der Kontur die Ausbildung eines höheren lokalen elektrischen Feldes zur Entladung des Gases und Erzeugung des Plasmas ermöglicht.

In einer bevorzugten Ausgestaltung ist die Oberflächenstruktur geeignet und/oder ausgebildet, im Zusammenwirken mit der Gegenelektrode an den Entladungsinitiationspunkten eine lokal erhöhte elektrische Feldstärkeverteilung auszubilden.

Der piezoelektrische Transformator liefert insbesondere die für die Entladung des Gases notwendige elektrische Spannung. Bei dem Gas kann es sich um ein stationäres oder ein durchströmendes beziehungsweise an dem piezoelektrischen Transformator und/oder der Gegenelektrode vorbeiströmenden Gas handeln.

Insbesondere kann durch den angegebenen piezoelektrischen Transformator eine Vorrichtung beispielsweise zur Behandlung von Oberflächen angegeben werden, welche effektiver betrieben werden kann. Die Effektivität kann sich dabei insbesondere auf den Ionisationsgrad des Gases oder den Wirkungsgrad beziehen. Weiterhin kann, beispielsweise im Fall von Luft als Gas, der Anteil des pro Zeiteinheit und Luftvolumen erzeugten Ozons erhöht werden. Durch die Vorsehung des piezoelektrischen Transformators kann weiterhin auf den Einsatz von Hochspannungszuleitungen von einer Hochspannungsquelle bis zur Entladungseinheit sowie auf den Einsatz von Hochspannungssteckkontakten sowie einer damit verbundenen Zündeinheit, verzichtet werden. Weiterhin kann eine besonders kompakte und einfache Vorrichtung zur Behandlung von Oberflächen angegeben werden, die sich insbesondere durch eine Platz- und Gewichtseffizienz und/oder wenige benötigte Bauteile oder Komponenten auszeichnet. Durch eine niedrige Anzahl von benötigten oder interagierenden Komponenten kann mit Vorteil wiederum die Zuverlässigkeit des Gesamtsystems erhöht werden, da dieses weniger fehleranfällig ist. Weiterhin erlaubt das vorgestellte Konzept mit Vorteil eine vereinfachte Zündung eines kalten Plasmas. Dabei kann unter Umständen auch auf den Einsatz einer Barriereentladungseinheit als Zündeinheit für das kalte Plasma verzichtet werden.

In einer bevorzugten Ausgestaltung weist die Oberflächenstruktur eine Elektrode auf oder bildet diese. Dadurch kann im Zusammenwirken mit der Gegenelektrode zur Erzeugung des Plasmas zwischen der Elektrode und der Gegenelektrode das Gas entladen werden.

In einer bevorzugten Ausgestaltung definiert das Oberflächenstruktursegment die Kontur des piezoelektrischen Transformators.

In einer bevorzugten Ausgestaltung weist die Oberflächenstruktur eine Vielzahl von Oberflächenstruktursegmenten auf, wobei zwischen benachbarten Oberflächenstruktursegmenten jeweils ein Zwischenraum angeordnet ist, und wobei die Oberflächenstruktursegmenten zusammen mit dem Zwischenraum die Oberflächenstruktur bilden. Vorzugsweise umschließt die Kontur im Gegensatz zu dem Oberflächenprofil die genannten Zwischenräume. Durch die Vielzahl der Oberflächenstruktursegmente kann insbesondere eine Vielzahl von Entladungsinitiationspunkten je nach Geometrie der Oberflächenstruktursegmente für die Erzeugung des Plasmas zur Verfügung gestellt werden. Dadurch wird energetisch betrachtet eine besonders effiziente Gasentladung ermöglicht, da das Gas zu einem besonders hohen Grad ionisiert werden kann.

In einer bevorzugten Ausgestaltung sind die Oberflächenstruktursegmente gleichartig ausgebildet. Durch diese Ausgestaltung kann das Gas mit Vorteil an der Oberfläche gleichförmig oder homogen entladen werden und über die Oberfläche verteilt ein homogenes Plasma erzeugt werden. Dies bietet insbesondere den Vorteil einer homogenen Oberflächenbehandlung, beispielsweise für eine Reinigung oder Entkeimung von Oberflächen.

In einer bevorzugten Ausgestaltung ist die Breite eines Oberflächenstruktursegments oder der Abstand zweier benachbarter Oberflächenstruktursegmente größer als 10 µm. Die Ausgestaltung ist besonders vorteilhaft für die Plasmaerzeugung, da auf diese Weise Mikroentladungen an der Oberfläche oder an der Oberflächenstruktur ausgebildet werden können. Mikroentladungen können eine Vielzahl von im Mikrometerbereich voneinander beabstandeten Gasentladungen bezeichnen.

In einer bevorzugten Ausgestaltung weist die Oberflächenstruktur ein Oberflächenprofil auf, wobei die Profiltiefe des Oberflächenprofils der Oberflächenstruktur größer als die Breite eines Oberflächenstruktursegments. Diese Ausgestaltung erhöht vorteilhafterweise ein Aspektverhältnis der Oberflächenstruktursegmente, beispielsweise im Querschnitt der Oberflächenstruktur betrachtet, wodurch - wie oben beschrieben - besonders zweckmäßig eine Geometrie der Oberflächenstruktur geschaffen werden kann, welche lokal die Ausbildung hoher elektrischer Felder zwischen dem piezoelektrischen Transformator und beispielsweise einer Gegenelektrode oder einer als Gegenelektrode fungierende Komponente ermöglicht. Das Oberflächenprofil weicht zweckmäßigerweise von der Kontur ab, in dem es beispielsweise in einem Querschnitt der Oberflächenstruktur betrachtet den tatsächlichen Verlauf der Oberflächenstruktur beschreibt oder bildet.

In einer bevorzugten Ausgestaltung liegen die Entladungsinitiationspunkte in einer Ebene. Durch die ebene Geometrie wird weiterhin mit Vorteil die, insbesondere flächige, Behandlung einer ebenen Oberfläche ermöglicht.

In einer bevorzugten Ausgestaltung sind die Oberflächenstruktursegmente im Querschnitt dreieckig, viereckig, zum Beispiel rechteckig oder weisen mehr als vier Ecken auf. Durch diese Ausgestaltung kann eine energetisch besonders effiziente Gasentladung im Zusammenwirken mit einer planaren Gegenelektrode ausgebildet werden. Die eckigen Geometrien der Oberflächenstruktursegmente erlauben weiterhin in einfacher und zweckmäßiger Weise die Ausbildung der Entladungsinitiationspunkte.

In einer bevorzugten Ausgestaltung erstreckt sich die Oberflächenstruktur zwischen 2 mm und 4 cm über die Breite des piezoelektrischen Transformators.

In einer Ausgestaltung hat die Oberflächenstruktur eine polygonale Gestalt hat und eine Mehrzahl von Oberflächenstruktursegmenten aufweist.

In einer Ausgestaltung ist das jeweilige Oberflächenstruktursegment durch den geraden Teil eines Polygonzugs bestimmt, wobei die Entladungsinitiationspunkte auf verschiedenen Ebenen liegen. Durch diese Ausgestaltung kann das Plasma derart geformt oder ausgebildet werden, dass beispielsweise im Vergleich zu einer ebenen Anordnung der Entladungsinitiationspunkte eine eher gerundete oder entsprechend der polygonalen Gestalt geformte Oberflächenbehandlung ermöglicht wird.

Entsprechend dieser Ausgestaltung ist die Oberflächenstruktur vorzugsweise zwischenraumfrei ausgebildet.

In einer Ausgestaltung weist die Oberflächenstruktur nur ein einziges Oberflächenstruktursegment auf, welches an der Ausgangsseite des piezoelektrischen Transformators eine Endfläche desselben definiert, wobei die Entladungsinitiationspunkte auf derselben Ebene liegen. Gemäß dieser Ausgestaltung beträgt die Breite des Oberflächenstruktursegments beispielsweise weniger als 100 µm, so dass auch der Abstand zwischen benachbarten Entladungsinitiationspunkten auf der Endfläche kleiner ist als z.B. 100 µm. Diese Ausgestaltung ermöglicht vorteilhafterweise eine eher gerichtete oder punktuelle, denn eine flächige Oberflächenbehandlung.

In einer Ausgestaltung verjüngt sich der piezoelektrische Transformator zu einer Ausgangsseite des piezoelektrischen Transformators hin.

In einer Ausgestaltung ist die Oberflächenstruktur durch mechanisches Bearbeiten eines Grundmaterials des piezoelektrischen Transformators einstückig mit dem piezoelektrischen Transformator abgeformt.

In einer Ausgestaltung weist der piezoelektrische Transformator einen Transformatorkörper auf der mit einem Strukturteil versehen ist, wobei die Oberflächenstruktur in dem Strukturteil ausgebildet ist, und wobei das Strukturteil relativ zu dem piezoelektrischen Transformator fest mit dem Transformatorkörper verbunden ist. Durch diese Ausgestaltung kann, ohne dass der piezoelektrische Transformator entsprechend ausgeführt oder bearbeitet werden muss, über die Ausbildung des Strukturteils, eine Oberflächenstruktur an für die Oberflächenbehandlung erforderliche Bedingungen angepasst und die oben genannten Vorteile genutzt werden. Bei dem Strukturteil kann es sich um ein elektrisch leitfähiges Material handeln, was insbesondere bei der konventionellen Plasmaerzeugung, das heißt ohne dielektrische Barriereentladung zweckmäßig ist. Alternativ kann es sich, im Falle einer dielektrischen Barriereentladung, um ein elektrisch isolierendes Strukturteil handeln.

In einer Ausgestaltung ist die Oberflächenstruktur elektrisch leitfähig. Diese Ausgestaltung ermöglicht eine konventionelle Plasmaerzeugung ohne dielektrische Barriereentladung. Der Verzicht auf die dielektrische Barriereentladung bietet insbesondere den Vorteil, bei der Erzeugung des Plasmas auf eine entsprechende Zünd- und/oder Barriereentladungseinheit verzichten zu können.

In einer alternativen Ausgestaltung ist die Oberflächenstruktur elektrisch isolierend, wobei die Gasentladung eine dielektrische Barriereentladung ist. Dielektrischen Barriereentladungen bieten beispielsweise gegenüber einem konventionellen Elektrodendesign Vorteile einer hohen Energieeffizienz, niedriger Plasmatemperaturen sowie geringer Materialverschleißerscheinungen.

Es wird weiterhin eine Vorrichtung mit dem piezoelektrischen Transformator angegeben, welche weiterhin eine Gegenelektrode aufweist, die, beispielsweise zur Erzeugung des Plasmas zwischen dem piezoelektrischen Transformator und der Gegenelektrode, der Oberflächenstruktur zugewandt angeordnet ist. Zweckmäßigerweise ist das Gas ebenfalls zwischen dem piezoelektrischen Transformator oder der Ausgangsseite desselben und der Gegenelektrode angeordnet. Die Vorrichtung bietet die oben bereits beschriebenen Vorteile.

In einer bevorzugten Ausgestaltung der Vorrichtung ist die Gegenelektrode planar ausgebildet.

In einer bevorzugten Ausgestaltung der Vorrichtung ist das Plasma ein niederenergetisches Atmosphärendruckplasma. Mit Vorteil kann durch diese Ausgestaltung beispielweise eine Luftumgebung als Gas zur Entladung herangezogen werden.

In einer bevorzugten Ausgestaltung der Vorrichtung ist das Gas Helium, Argon, Stickstoff oder Luft.

Es wird weiterhin eine Gegenelektrode aufweisend eine Oberflächenstruktur, die zumindest ein hervorstehendes Oberflächenstruktursegment aufweist, wobei die Gegenelektrode eine Kontur aufweist und geeignet ist, im Zusammenwirken mit einem piezoelektrischen Transformator zur Erzeugung eines Plasmas, ein Gas zu entladen, wobei die Gasentladung an einer Vielzahl von, beispielsweise diskreten, Entladungsinitiationspunkten auf der Kontur der Oberflächenstruktur einsetzt.

Insbesondere können sich sämtliche für den piezoelektrischen Transformator offenbarte Merkmale auch auf die Gegenelektrode beziehen, und umgekehrt. Weiterhin können sich die Vorteile für die Gegenelektrode mit der Oberflächenstruktur analog zu denjenigen des piezoelektrischen Transformators mit der Oberflächenstruktur ergeben.

In einer bevorzugten Ausgestaltung der Gegenelektrode weist die Oberflächenstruktur eine Vielzahl von Oberflächenstruktursegmenten auf, wobei zwischen den Oberflächenstruktursegmenten Zwischenräume angeordnet sind, und wobei die Zwischenräume zusammen mit den Oberflächenstruktursegmenten die Oberflächenstruktur bilden.

In einer bevorzugten Ausgestaltung der Gegenelektrode erstreckt sich die Oberflächenstruktur an einer Innenseite der Gegenelektrode entlang. Durch diese Ausgestaltung ist eine Vorrichtung zur Behandlung von Oberflächen denkbar, bei der in einem von der Gegenelektrode definierten Hohlraum ein piezoelektrischer Transformator angeordnet ist.

In einer Ausgestaltung der Gegenelektrode erstreckt sich die Oberflächenstruktur entlang einer Länge der Gegenelektrode.

Es wird weiterhin eine Vorrichtung mit einer Gegenelektrode und dem piezoelektrischen Transformator angegeben, wobei die Vorrichtung ausgebildet ist, das Gas zwischen der Oberflächenstruktur und dem piezoelektrischen Transformator zu entladen.

In einer bevorzugten Ausgestaltung der zuletzt genannten Vorrichtung ist der piezoelektrische Transformator zumindest teilweise innerhalb eines von der Gegenelektrode gebildeten Hohlraums angeordnet. Diese Ausgestaltung ermöglicht mit Vorteil eine koaxiale Anordnung von Gegenelektrode und piezoelektrischem Transformator.

In einer bevorzugten Ausgestaltung der zuletzt genannten Vorrichtung ist der piezoelektrische Transformator in der Vorrichtung koaxial mit der Gegenelektrode angeordnet.

Ein weiterer Aspekt betrifft die Verwendung einer Vorrichtung zur Hydrophobisierung von Oberflächen, zur Erhöhung der Haftung von Kunststofffolien oder zur medizinischen Wundbehandlung.

Weitere Vorteile, vorteilhafte Ausgestaltungen und Zweckmäßigkeiten der Erfindung ergeben sich aus der folgenden Beschreibung der Ausführungsbeispiele in Verbindung mit den Figuren.

Figur 1A zeigt schematisch eine Ausgestaltung eines piezoelektrischen Transformators mit einer Oberflächenstruktur.

Figur 1B zeigt schematisch eine Vorrichtung mit einem piezoelektrischen Transformators gemäß einer alternativen Ausführungsform.

Figur 1C zeigt schematisch einen Teil einer Ausgestaltung des piezoelektrischen Transformators gemäß Figur 1B.

Figur 1D zeigt schematisch eine Frontansicht des piezoelektrischen Transformators gemäß einer alternativen Ausgestaltung.

Figur 1E zeigt schematisch eine Aufsicht des piezoelektrischen Transformators gemäß Figur 1D.

Die Figuren 2A und 2B zeigen schematisch jeweils eine Seitenansicht von alternativen Ausgestaltungen von Oberflächenstrukturen des piezoelektrischen Transformators.

Figur 3 zeigt schematisch eine alternative Ausgestaltung des piezoelektrischen Transformators mit einem Strukturteil.

Figur 4 zeigt schematisch eine Vorrichtung zur Behandlung von Oberflächen mit einem piezoelektrischen Transformator und einer Gegenelektrode.

Die Figuren 5A und 5B zeigen schematisch jeweils verschiedene Ausgestaltungen der Gegenelektrode gemäß Figur 4.

Gleiche, gleichartige und gleich wirkende Elemente sind in den Figuren mit gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

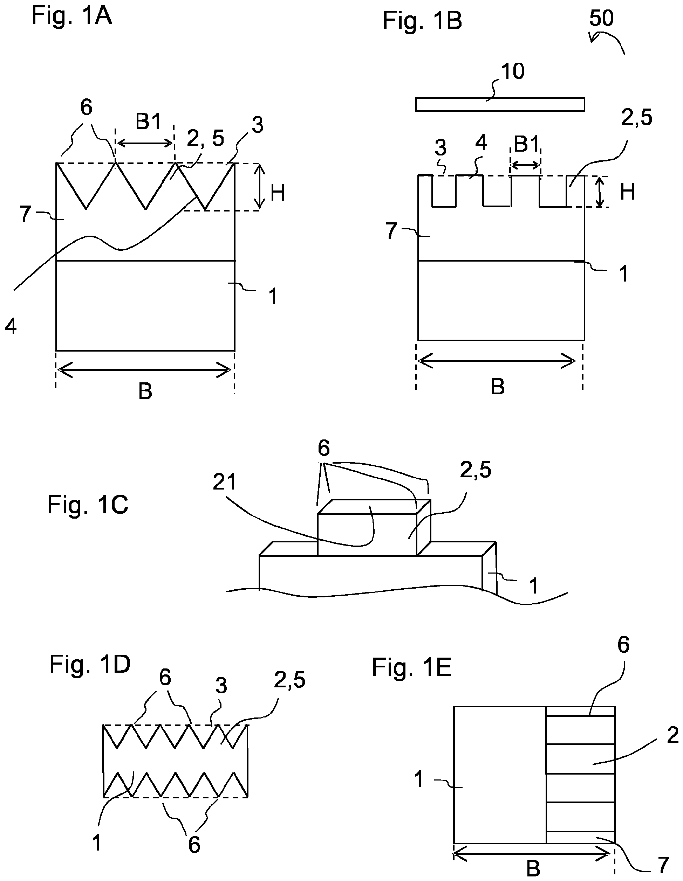

Figur 1A zeigt einen piezoelektrischen Transformator 1. Der piezoelektrische Transformator 1 kann monolithisch oder in Vielschichtbauweise hergestellt sein. Der piezoelektrische Transformator 1 ist vorzugsweise weiterhin ein keramischer piezoelektrischer Transformator. Ein solcher kann zweckmäßigerweise zur Sicherung der Spannungsversorgung für eine Gasentladung zur Erzeugung eines Plasmas eingesetzt werden.

Der piezoelektrische Transformator 1 weist eine Ausgangsseite 7 auf. Die Ausgangsseite 7 bezeichnet zweckmäßigerweise eine Seite des piezoelektrischen Transformators 1, an der oder über die eine entsprechend transformierte Ausgangsspannung abgegriffen werden kann. Eine Eingangsseite des piezoelektrischen Transformators 1 ist nicht explizit gekennzeichnet. Die Breite des piezoelektrischen Transformators 1 ist mit B gekennzeichnet.

An der Ausgangsseite 7 weist der piezoelektrische Transformator 1 weiterhin eine Oberflächenstruktur 2 auf. Die Oberflächenstruktur 2 erstreckt sich über die gesamte Breite B des piezoelektrischen Transformators. Die Oberflächenstruktur 2 weist ein Oberflächenprofil 4 mit einer Vielzahl von Oberflächenstruktursegmenten 5 auf. Die Profiltiefe des Oberflächenprofils 4 beziehungsweise die Höhe der Oberflächenstruktursegmente 5 ist mit H gekennzeichnet. Die Profiltiefe H des Oberflächenprofils 4 der Oberflächenstruktur ist vorzugsweise größer ist als der Abstand zweier benachbarter Oberflächenstruktursegmente 5 oder als eine Breite B1 der Oberflächenstruktursegmente 5. Die Breite B beträgt vorzugsweise zwischen 2 mm und 4 cm.

Vorzugsweise verläuft die Breite B des piezoelektrischen Transformators 1 senkrecht zu einer Höhe (in den Figuren nicht explizit gekennzeichnet) und einer Länge (siehe weiter unten) desselben. Für eine Vorrichtung aufweisend den piezoelektrischen Transformator 1 und mit einer Gegenelektrode (vgl. Bezugszeichen 10 unten) befindet sich die Gegenelektrode relativ zum piezoelektrischen Transformator 1 weiterhin vorzugsweise längsseitig gegenüber der Oberflächenstruktur 2 und/oder auf gleicher Höher der Oberflächenstruktur 2. Alternativ oder zusätzlich kann die Gegenelektrode der Oberflächenstruktur 2 zweckmäßigerweise zugewandt sein.

Die Breite B1 ist vorzugsweise um ein Vielfaches kleiner als die Breite B des piezoelektrischen Transformators 1.

Die Breite B1 der Oberflächenstruktursegmente 5 kann dem Abstand zweier benachbarter Oberflächenstruktursegmente 5 entsprechen, wie in Figur 1A dargestellt.

Die Oberflächenstruktursegmente 5 sind im Querschnitt oder von der Seite betrachtet jeweils dreieckig geformt und in einer Ebene angeordnet. Die Oberflächenstruktursegmente 5 sind weiterhin gleichartig ausgebildet.

Gemäß der dargestellten Ausführungsform sind die Oberflächenstruktursegmente 5 durch die im Querschnitt dreieckigen Segmente oder Teile der Oberfläche der Oberflächenstruktur 2 gebildet.

Bei der Darstellung der Figuren 1A und 1B kann es sich um eine Längsschnitts- oder um eine Seitenansicht des piezoelektrischen Transformators 1 handeln.

Zwischen benachbarten Oberflächenstruktursegmenten ist jeweils ein Zwischenraum (nicht explizit gekennzeichnet) angeordnet, wobei die Oberflächenstruktursegmente 5 zusammen mit den Zwischenräumen die Oberflächenstruktur 2 bilden.

Die Oberflächenstruktursegmente 5 definieren weiterhin eine Kontur 3 der Oberflächenstruktur 2. Die Breite eines Oberflächenstruktursegments 5 und/oder der Abstand zweier benachbarter Oberflächenstruktursegmente 5 ist vorzugsweise größer als 10 µm.

An den seitlichen Rändern der Oberflächenstruktur 2, sind die Oberflächenstruktursegmente 5 jeweils nur über die Hälfte der Breite B1 beziehungsweise jeweils durch die Seitenkanten des piezoelektrischen Transformators 1 abgeschnitten ausgebildet.

Dies kann bei der Fertigung des piezoelektrischen Transformators 1, insbesondere durch den Zuschnitt eines Grundkörpers für den piezoelektrischen Transformator zweckmäßig sein oder eine Vereinfachung bedeuten.

Der piezoelektrische Transformator 1 ist vorzugsweise geeignet im Zusammenwirken mit einer Gegenelektrode (vgl. Bezugszeichen 10 in Figur 1B) zur Erzeugung eines Plasmas, ein Gas zu entladen, wobei die Entladung an einer Vielzahl von, beispielsweise diskreten, Entladungsinitiationspunkten 6 auf der Kontur 3 der Oberflächenstruktur 2 erfolgt. Die Entladungsinitiationspunkten 6 stellen vorzugsweise ausgangsseitig äußerste Punkte oder Bereiche des piezoelektrischen Transformators beziehungsweise der Oberflächenstruktur 2 da. Diese befinden sich in Figur 1A an den Punkten, an denen die Oberflächenstruktur 2 oder die Oberflächenstruktursegmente 5 die Kontur 3 tangieren. In den Entladungsinitiationspunkten 6 kann eine Gasentladung vorzugsweise am einfachsten und/oder energetisch am günstigsten initiiert werden.

Eine Gasentladung kann im Betrieb des piezoelektrischen Transformators vorteilhafterweise an den Entladungsinitiationspunkten 6 auf der Kontur 3 der Oberflächenstruktur 2 einsetzen oder erfolgen, da der geometrische Abstand der Entladungsinitiationspunkte 6 relativ zu einer als Gegenelektrode des piezoelektrischen Transformators 1 fungierenden Komponente (vgl. 10 in Figur 1B) kleiner ist als an Oberflächenpunkten 5 der Oberflächenstruktur 2, welche nicht auf der Kontur 3 liegen. Bei der als Gegenelektrode fungierenden Komponente kann es sich beispielsweise um eine gegenüber der Oberflächenstruktur 2 angeordnete, vorzugsweise planaren, Gegenelektrode handeln.

Alternativ kann es sich dabei um ein Plasma an sich handeln. Alternativ kann es sich dabei um eine durch das Plasma zu Behandelnde Oberfläche handeln.

Durch den geringeren geometrischen Abstand der genannten Komponente, kann vorzugsweise in den Entladungsinitiationspunkten 6 eine lokal erhöhte elektrische Feldstärkeverteilung ausgebildet und der Grad der Ionisation des Gases beziehungsweise des Plasmas erhöht werden.

Figur 1B zeigt eine Vorrichtung 100 zur Behandlung von Oberflächen. Die Vorrichtung 100 umfasst einen piezoelektrischen Transformator 1 gemäß einer alternativen Ausgestaltung. Bei dem piezoelektrischen Transformator 1 sind, im Gegensatz zu demjenigen aus Figur 1A, die Oberflächenstruktursegmente 5 der Oberflächenstruktur 2 im Querschnitt rechteckig oder quadratisch ausgebildet. Entsprechend den Oberflächenstruktursegmenten 5 sind auch die Zwischenräume zwischen diesen rechteckig oder quadratisch geformt, um die Oberflächenstruktursegmente 5 zu bilden.

Obwohl dies nicht explizit dargestellt ist, können die Oberflächenstruktursegmente auch weitere zweckmäßige Formen umfassen und im Querschnitt beispielsweise polygonal sein und/oder mehr als vier Ecken aufweisen.

Anders als in den Figuren 1A und 1B dargestellt, kann die Oberflächenstruktur auch so ausgebildet sein, dass diese beziehungsweise die Oberflächenstruktursegmente sich, anstatt über die Breite B des piezoelektrischen Transformators, entlang dessen Tiefe oder Höhe (in den Figuren 1A und 1B in die Darstellungsebene hinein) erstrecken.

Die Vorrichtung 100 weist weiterhin eine Gegenelektrode 10 auf. Die Gegenelektrode 10 ist der Oberflächenstruktur 2 des piezoelektrischen Transformators 1 zugewandt und zu diesem beabstandet angeordnet. Die Vorrichtung 100 ist vorzugsweise eine Vorrichtung zur Behandlung von Oberflächen mittels eines Plasmas. In dem Zwischenraum zwischen dem piezoelektrischen Transformators 1 und der Gegenelektrode 10 ist im Betrieb der Vorrichtung vorzugsweise ein Gas angeordnet, welches zur Erzeugung des Plasmas mittels der Vorrichtung 100 und eventuell weiteren Komponenten zur Erzeugung des Plasmas entladen werden kann. Die Gegenelektrode 10 ist planar ausgebildet. Alternativ könnte die Gegenelektrode 10, statt des piezoelektrischen Transformators die beschriebene Oberflächenstruktur aufweisen. Demgemäß kann jedes für die Oberflächenstruktur beschriebene Merkmal sich auf den piezoelektrischen Transformator und/oder die Gegenelektrode beziehen.

Figur 1C zeigt schematisch eine perspektivische, vergrößerte Ansicht eines einzelnen Oberflächenstruktursegments 5 gemäß der in Figur 1A gezeigten Ausgestaltung. Die Entladungsinitiationspunkte 6 befinden sich vorzugsweise an den Seitenkanten oder Ecken eines jeden Oberflächenstruktursegments 5. Eine Endfläche der Ausgangsseite des piezoelektrischen Transformators ist mit dem Bezugszeichen 21 gekennzeichnet.

Figur 1D zeigt eine Frontansicht, Stirnseite oder einen Querschnitt des piezoelektrischen Transformators 1 in einer alternativen Ausgestaltung, bei dem ausgangsseitig gegenüberliegende Oberflächen mit der Oberflächenstruktur 2 versehen sind.

In Figur 1E ist eine Aufsicht auf einen piezoelektrischen Transformator 1 gemäß der Ausgestaltung der Figur 1D gezeigt. Die Entladungsinitiationspunkte 6 sind in Figur 1E auf der Ausgangsseite 7 mit horizontalen Linien angedeutet, auf welchen Entladungsinitiationspunkten 6 angeordnet sein können oder sich ausbilden können. Eine Gasentladung kann demnach vorzugsweise auf den genannten Linien erfolgen.

Gemäß dieser Ausgestaltung erstrecken sich die Oberflächenstruktursegmente 5 (im Gegensatz zu den Figuren 1A und 1B) entlang einer Hauptoberfläche und teilweise entlang einer Länge L des piezoelektrischen Transformators 1 (vgl. auch Figur 1E). Vorzugsweise erstrecken sich, wie dargestellt, die Oberflächenstruktursegmente 5 über die gesamte Ausgangsseite 7 des piezoelektrischen Transformators 1. Die Länge L kann sich in den Figuren 1A und 1B vertikal, d.h. senkrecht zur Breite B erstrecken.

Die in den Figuren 1D und 1E gezeigten Ausgestaltungen sind insbesondere für piezoelektrische Transformatoren geeignet, welche beispielsweise für Vorrichtungen für eine besonders gerichtete Oberflächenbehandlung ausgelegt sind.

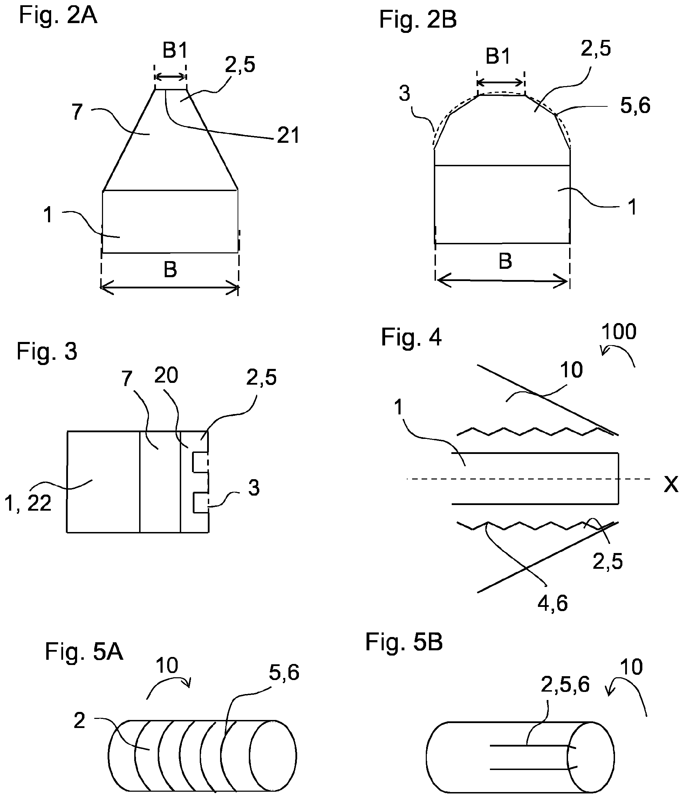

Figur 2A zeigt eine alternative Ausgestaltung eines piezoelektrischen Transformators 1, bei dem die Oberflächenstruktur 2 lediglich ein einziges Oberflächenstruktursegment 5 aufweist. Das Oberflächenstruktursegment 5 ist durch eine ausgangsseitige Verjüngung des piezoelektrischen Transformators 1 gebildet. Insbesondere ist der piezoelektrische Transformator ausgangsseitig der Länge nach bis zu der ausgangsseitigen Endfläche 21 verjüngt, wobei die Oberflächenstruktur 2 zumindest teilweise durch die Endfläche 21 definiert ist.

Gemäß dieser Ausgestaltung ist das Oberflächenstruktursegment 5 durch die Endfläche 21 bestimmt ist. Die Breite B1 ist hier vorzugsweise wesentlich kleiner als die Breite B und als eine Längsausdehnung der Ausgangsseite 7. Die Breite B1 des Oberflächenstruktursegments kann beispielsweise im Mikrometer- oder Millimeterbereich liegen.

Figur 2B zeigt eine weitere alternative Ausgestaltung eines piezoelektrischen Transformators 1. Die Oberflächenstruktur 2 weist in diesem Fall eine Mehrzahl von Oberflächenstruktursegment 5 auf, welche beispielsweise im Gegensatz zu denen aus den Figuren 1A, 1B und 1E nicht in einer Ebene, sondern in verschiedenen Ebenen angeordnet sind. Die Oberflächenstruktur 2 ist stattdessen im Querschnitt vieleckig oder polygonal ausgeführt, derart dass die Entladungsinitiationspunkte vorzugsweise auf den Ecken oder Kanten der Oberflächenstruktur 2 angeordnet sind. Insbesondere hat die Oberflächenstruktur 2 eine polygonale Gestalt, wobei das jeweilige Oberflächenstruktursegment 5 durch einen geraden Teil des Polygonzugs bestimmt ist. Gemäß der Oberflächenstruktursegment 5 sind die Entladungsinitiationspunkte 6 auf verschiedenen Ebenen angeordnet. Die Kontur 3, welche (wie oben beschrieben) durch die Oberflächenstruktursegmente 5 definiert wird, verläuft halbkreisförmig.

Figur 3 zeigt eine alternative Ausgestaltung eines piezoelektrischen Transformators 1, welcher von sich aus oder aus demselben Grundkörper geformt keine Oberflächenstruktur aufweist. Stattdessen wird bei der Fertigung oder Herstellung des piezoelektrischen Transformators 1, ein Transformatorkörper 22 mit einem Strukturteil 20 versehen. Die Strukturteil 20 weist vorzugsweise die Oberflächenstruktur 2 auf. Diese weist in Figur 3 rechteckige Oberflächenstruktursegmente 5 gemäß Figur 1B auf. Alternativ kann die Oberflächenstruktur 2 entsprechend jeder hier beschriebenen Oberflächenstruktur 2 ausgestaltet sein. Die Strukturteil 20 ist beispielsweise fest mit geeigneten Mitteln ausgangsseitig an den Transformatorkörper 22 angebracht oder angeformt.

Die Strukturteil 20 ist relativ zu dem piezoelektrischen Transformator 1 zweckmäßigerweise mechanisch starr mit diesem verbunden, so dass die Strukturteil 20 im Betrieb des piezoelektrischen Transformators beispielsweise die mechanische Schwingung des piezoelektrischen Transformators 1 aufnehmen kann. Dabei kann das Strukturteil 20 mittelbar oder unmittelbar, an dem piezoelektrischen Transformator 1 angebracht sein.

Die Oberflächenstruktur 2 kann im Rahmen der vorliegenden Anmeldung und im Falle eines konventionellen Elektrodendesigns, elektrisch leitfähig ausgebildet sein. Im Falle der Erzeugung eines Plasmas durch eine dielektrische Barriereentladung kann die Oberflächenstruktur 2 alternativ auch elektrisch isolierend ausgebildet sein.

Bei einer Barriereentladungseinheit wird beispielsweise zur Erzeugung eines kalten Plasmas ein stationäres oder vorbeiströmendes Gas ionisiert. Die für die Entladung notwendigen elektrischen Spannungen können Wechselspannungen von einigen tausend Volt umfassen.

Insbesondere bedeutet eine dielektrische Barriereentladung, dass sich die Hochspannung zwar zwischen Elektroden aufbaut, von denen jedoch mindestens eine durch ein Dielektrikum abgeschirmt ist.

Figur 4 zeigt schematisch eine alternative Ausgestaltung der Vorrichtung 100. Die Darstellung ist vorzugsweise eine Seiten- oder Querschnittsansicht der Vorrichtung 100. Die Vorrichtung 100 umfasst einen piezoelektrischen Transformator 1. Die Vorrichtung 100 umfasst weiterhin eine Gegenelektrode 10. Im Gegensatz zu der in Figur 1B gezeigten Vorrichtung weist die Gegenelektrode 10 (statt des piezoelektrischen Transformators 1) die Oberflächenstruktur 2 auf. Die Oberflächenstruktur 2 ist gemäß derjenigen aus Figur 1A mit in der Schnittansicht dreieckigen Oberflächenstruktursegmenten 5 ausgebildet; Die Oberflächenstruktur kann jedoch auch analog zu allen hier beschriebenen Oberflächenstrukturen ausgebildet sein.

Der piezoelektrische Transformator 1 in einem von der Gegenelektrode 10 definierten Hohlraum oder Zwischenraum (nicht explizit gekennzeichnet) angeordnet. Der piezoelektrische Transformator 1 ist weiterhin koaxial mit dem piezoelektrischen Transformator 1 um eine Längsachse X der Vorrichtung 100 angeordnet. In Figur 4 erstreckt sich die Oberflächenstruktur vorzugsweise maßgeblich über die Länge der Gegenelektrode 10 und/oder des piezoelektrischen Transformators 1.

Ein Gas (nicht explizit dargestellt) zur Entladung eines Plasmas kann stationär in dem Zwischen- oder Hohlraum zwischen der Gegenelektrode 10 und dem piezoelektrischen Transformator 1 angeordnet sein oder dort hindurch strömen. Bei dem Gas kann es sich um Helium, Argon, Stickstoff, Luft, beispielsweise Umgebungsluft oder ein anderes Gas handeln.

Das Plasma ist vorzugsweise ein niederenergetisches Atmosphärendruckplasma.

In Figur 5A ist schematisch eine Gegenelektrode 10 gezeigt, welche, sofern sich Figur 4 auf einen Querschnitt der Vorrichtung 100 bezieht analog zu der in Figur 4 gezeigten Oberflächenstruktur 2 ausgebildet ist. Die Oberflächenstruktur 2 ist derart ausgebildet, dass die Entladungsinitiationspunkte 6 sich umfänglich um die Gegenelektrode 10 erstrecken. Die möglichen Entladungsinitiationspunkte 6 sind durch die Linien angedeutet.

Figur 5B zeigt schematisch eine alternative Ausgestaltung einer Gegenelektrode 10, bei der die Oberflächenstruktur 2 derart ausgebildet ist, dass die Entladungsinitiationspunkte 6 entlang einer Längsachse X der Gegenelektrode 10 verlaufen.

Durch die Ausbildung der Oberflächenstruktur samt Oberflächenstruktursegmenten und Entladungsinitiationspunkten kann insbesondere die Anzahl der Gasentladungen an der Oberfläche des piezoelektrischen Transformators oder der Gegenelektrode maximiert und damit der Ionisationsgrad des Plasmas zur Behandlung von Oberflächen erhöht werden. Dies kann wiederum zu einer energetisch effizienteren als auch räumlich homogeneren Oberflächenbehandlung führen.

Die Behandlung von Oberflächen betrifft vorzugsweise die Hydrophobisierung von Oberflächen, die Erhöhung der Haftung von Kunststofffolien und/oder die medizinische Wundbehandlung.

Im Falle einer Oberflächenbehandlung mit Ozon, wird vorzugsweise Umgebungsluft als Gas für die Gasentladung zur Erzeugung des Plasmas verwendet. Eine Feineinstellung der erzeugten Plasmageometrie kann in diesem Fall durch eine pulsweitenmodulierte Ansteuerung des piezoelektrischen Transformators erreicht werden.

Weiterhin kann im Falle einer Oberflächenbehandlung mit Ozon durch die Vorrichtung mit einer Mehrfachanordnung von piezoelektrischen Transformatoren samt Strukturteilen ein Wirkungsgrad für die Plasmaerzeugung beziehungsweise Ozongenerierung weiter erhöht werden.

Die Erfindung ist nicht durch die Beschreibung anhand der Ausführungsbeispiele beschränkt. Vielmehr umfasst die Erfindung jedes neue Merkmal sowie jede Kombination von Merkmalen was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

### Bezugszeichenliste

- 1: Piezoelektrischer Transformator
- 2: Oberflächenstruktur
- 3: Kontur
- 4: Oberflächenprofil
- 5: Oberflächenstruktursegment
- 6: Entladungsinitiationspunkt
- 7: Ausgangsseite
- 10: Gegenelektrode
- 20: Strukturteil
- 21: Endfläche
- 22: Transformatorkörper
- 100: Vorrichtung

- X: Longitudinale Achse
- L: Länge
- B, B1: Breite
- H: Profiltiefe

## Patentansprüche

1. Piezoelektrischer Transformator (1) mit einer Oberflächenstruktur (2),
wobei in einem Zwischenraum zwischen dem piezoelektrischen Transformators (1) und einer Gegenelektrode (10) ein Gas angeordnet ist, wobei der piezoelektrische Transformator (1) eine Kontur (3) aufweist und geeignet ist, im Zusammenwirken mit der Gegenelektrode (10) zur Erzeugung eines Plasmas das Gas zu entladen, wobei die Oberflächenstruktur so ausgebildet ist, dass die Gasentladung an einer Vielzahl von Entladungsinitiationspunkten (6) auf der Kontur (3) einsetzt, wobei die Breite (B1) eines Oberflächenstruktursegments (5) der Oberflächenstruktur (2) kleiner ist als die Breite (B) des piezoelektrischen Transformators (1), und
wobei die Oberflächenstruktur (2) eine polygonale Gestalt hat und eine Mehrzahl von Oberflächenstruktursegmenten (5) aufweist, und **dadurch gekennzeichnet, dass** die Oberflächenstruktur zumindest ein hervorstehendes Oberflächenstruktursegment (5) aufweist.

2. Piezoelektrischer Transformator (1) nach Anspruch 1, wobei das Oberflächenstruktursegment (5) die Kontur (3) des piezoelektrischen Transformators (1) definiert.

3. Piezoelektrischer Transformator (1) nach Anspruch 1 oder 2, wobei die Breite (B1) des Oberflächenstruktursegments (5) größer ist als 10 µm.

4. Piezoelektrischer Transformator (1) nach mindestens einem der vorhergehenden Ansprüche, wobei sich die Oberflächenstruktur zwischen 2 mm und 4 cm über die Breite (B1) des piezoelektrischen Transformators (1) erstreckt.

5. Piezoelektrischer Transformator (1) nach mindestens einem der vorhergehenden Ansprüche, wobei die Oberflächenstruktur (2) eine Vielzahl von Oberflächenstruktursegmenten (5) aufweist, wobei zwischen benachbarten Oberflächenstruktursegmenten (5) jeweils ein Zwischenraum angeordnet ist, und wobei die Oberflächenstruktursegmenten (5) zusammen mit dem Zwischenraum die Oberflächenstruktur (2) bilden.

6. Piezoelektrischer Transformator (1) nach Anspruch 5, wobei die Oberflächenstruktur (2) ein Oberflächenprofil (4) aufweist, und wobei die Profiltiefe (H) des Oberflächenprofils (4) der Oberflächenstruktur (2) größer ist als die Breite (B1) eines Oberflächenstruktursegments (5).

7. Piezoelektrischer Transformator (1) nach Anspruch 5 oder 6, wobei die Entladungsinitiationspunkte (6) in einer Ebene liegen, und wobei die Oberflächenstruktursegmente (5) im Querschnitt dreieckig, viereckig, zum Beispiel rechteckig, sind oder mehr als vier Ecken aufweisen.

8. Piezoelektrischer Transformator (1) nach mindestens einem der Ansprüche 1 bis 4, wobei das jeweilige Oberflächenstruktursegment (5) durch den geraden Teil eines Polygonzugs bestimmt ist, und wobei die Entladungsinitiationspunkte (6) auf verschiedenen Ebenen liegen.

9. Piezoelektrischer Transformator (1) nach Anspruch 1 bis 4, wobei die Oberflächenstruktur (2) nur ein einziges Oberflächenstruktursegment (5) aufweist, welches an der Ausgangsseite des piezoelektrischen Transformators (1) eine Endfläche desselben definiert und wobei die Entladungsinitiationspunkte (6) auf derselben Ebene liegen.

10. Piezoelektrischer Transformator (1) nach mindestens einem der vorhergehenden Ansprüche, welcher sich zu einer Ausgangsseite des piezoelektrischen Transformators (1) hin verjüngt.

11. Piezoelektrischer Transformator (1) nach mindestens einem der vorhergehenden Ansprüche, wobei der piezoelektrische Transformator (1) einen Transformatorkörper aufweist, der mit einem Strukturteil (20) versehen ist, wobei die Oberflächenstruktur (2) in dem Strukturteil (20) ausgebildet ist, und wobei das Strukturteil (20) fest mit dem Transformatorkörper verbunden ist.

12. Piezoelektrischer Transformator (1) nach mindestens einem der vorhergehenden Ansprüche, wobei die Oberflächenstruktur (2) elektrisch leitfähig ist.

13. Piezoelektrischer Transformator (1) nach mindestens einem der Ansprüche 1 bis 11, wobei die Oberflächenstruktur (2) elektrisch isolierend ist, und wobei die Gasentladung eine dielektrische Barriereentladung ist.

14. Piezoelektrischer Transformator (1) nach mindestens einem der vorherigen Ansprüche,
wobei die Kontur (3), die durch die Oberflächenstruktursegmente (5) definiert wird, halbkreisförmig verläuft.

15. Vorrichtung (100) mit einem piezoelektrischen Transformator (1) nach mindestens einem der vorhergehenden Ansprüche, wobei die Vorrichtung (100) eine Gegenelektrode (10) aufweist, die der Oberflächenstruktur (2) zugewandt angeordnet ist und, wobei die Gegenelektrode (10) planar ausgebildet ist.

16. Gegenelektrode (10) aufweisend eine Oberflächenstruktur (2), die zumindest ein hervorstehendes Oberflächenstruktursegment (5) aufweist, wobei die Gegenelektrode (10) mit einem piezoelektrischen Transformator derart verbindbar ist, dass in einem Zwischenraum zwischen der Gegenelektrode (10) und dem piezoelektrischen Transformator ein Gas angeordnet ist, wobei die Gegenelektrode (10) eine Kontur (3) ausweist und geeignet ist, im Zusammenwirken mit dem piezoelektrischen Transformator (1) zur Erzeugung eines Plasmas, das Gas zu entladen, wobei die Gasentladung an einer Vielzahl von Entladungsinitiationspunkten (6) auf der Kontur (3) einsetzt.

17. Gegenelektrode (10) nach Anspruch 16, wobei die Oberflächenstruktur (2) eine Vielzahl von Oberflächenstruktursegmenten (5) aufweist, wobei zwischen den Oberflächenstruktursegmenten (5) Zwischenräume angeordnet sind, und wobei die Zwischenräume zusammen mit den Oberflächenstruktursegmenten (5) die Oberflächenstruktur (2) bilden.

18. Vorrichtung (100) mit einer Gegenelektrode (1) nach Anspruch 16 oder 17 und einem piezoelektrischen Transformator (1), wobei die Vorrichtung (100) ausgebildet ist, das Gas zwischen der Oberflächenstruktur (2) und dem piezoelektrischen Transformator (1) zu entladen.

19. Vorrichtung (100) nach Anspruch 18, wobei der piezoelektrische Transformator (1) zumindest teilweise innerhalb eines von der Gegenelektrode (10) gebildeten Hohlraums angeordnet ist.

20. Vorrichtung (100) nach einem der Ansprüche 18 oder 19, wobei es sich bei dem piezoelektrischen Transformator um einen Transformator gemäß einem der Ansprüche 1 bis 14 handelt.

## Claims

1. Piezoelectric transformer (1) having a surface structure (2), wherein a gas is arranged in a gap between the piezoelectric transformer (1) and a counter electrode (10), wherein the piezoelectric transformer (1) has a contour (3) and is suitable for discharging the gas in conjunction with the counter electrode (10) for generating a plasma, wherein the surface structure is configured such that the gas discharge takes place at a multiplicity of discharge initiation points (6) on the contour (3), and wherein the width (B1) of a surface structure segment (5) of the surface structure (2) is smaller than the width (B) of the piezoelectric transformer (1), and wherein the surface structure (2) has a polygonal design and comprises a plurality of surface structure segments (5), and **characterized in that** the surface structure has at least one protruding surface structure segment (5).

2. Piezoelectric transformer (1) according to Claim 1, wherein the surface structure segment (5) defines the contour (3) of the piezoelectric transformer (1).

3. Piezoelectric transformer (1) according to Claim 1 or 2, wherein the width (B1) of the surface structure segment (5) is greater than 10 µm.

4. Piezoelectric transformer (1) according to at least one of the preceding claims, wherein the surface structure extends between 2 mm and 4 cm over the width (B1) of the piezoelectric transformer (1).

5. Piezoelectric transformer (1) according to at least one of the preceding claims, wherein the surface structure (2) has a plurality of surface structure segments (5), wherein a gap is arranged in each case between adjacent surface structure segments (5), and wherein the surface structure segments (5), together with the gap, form the surface structure (2).

6. Piezoelectric transformer (1) according to Claim 5, wherein the surface structure (2) has a surface profile (4), and wherein the profile depth (H) of the surface profile (4) of the surface structure (2) is greater than the width (B1) of a surface structure segment (5).

7. Piezoelectric transformer (1) according to Claim 5 or 6, wherein the discharge initiation points (6) lie in a plane, and wherein the surface structure segments (5) in cross section are triangular, quadrangular, for example rectangular, or have more than four corners.

8. Piezoelectric transformer (1) according to at least one of Claims 1 to 4, wherein the respective surface structure segment (5) is determined by the straight part of a polygonal line, and wherein the discharge initiation points (6) lie in different planes.

9. Piezoelectric transformer (1) according to Claim 1 to 4, wherein the surface structure (2) has just a single surface structure segment (5), which on the output side of the piezoelectric transformer (1) defines an end face thereof, and wherein the discharge initiation points (6) lie in the same plane.

10. Piezoelectric transformer (1) according to at least one of the preceding claims, which tapers toward an output side of the piezoelectric transformer (1).

11. Piezoelectric transformer (1) according to at least one of the preceding claims, wherein the piezoelectric transformer (1) has a transformer body which is provided with a structural part (20), wherein the surface structure (2) is formed in the structural part (20), and wherein the structural part (20) is fixedly connected to the transformer body.

12. Piezoelectric transformer (1) according to at least one of the preceding claims, wherein the surface structure (2) is electrically conductive.

13. Piezoelectric transformer (1) according to at least one of Claims 1 to 11, wherein the surface structure (2) is electrically insulating, and wherein the gas discharge is a dielectric barrier discharge.

14. Piezoelectric transformer (1) according to at least one of the preceding claims, wherein the contour (3), which is defined by the surface structure segments (5), extends semi-circularly.

15. Device (100) having a piezoelectric transformer (1) according to at least one of the preceding claims, wherein the device (100) comprises a counter electrode (10) which is arranged facing toward the surface structure (2), and wherein the counter electrode (10) is planar.

16. Counter electrode (10) comprising a surface structure (2) which comprises at least one protruding surface structure segment (5), wherein the counter electrode (10) can be connected to a piezoelectric transformer in such a way that a gas is arranged in a gap between the counter electrode (10) and the piezoelectric transformer, wherein the counter electrode (10) has a contour (3) and is suitable for discharging the gas in conjunction with the piezoelectric transformer (1) for generating a plasma, wherein the gas discharge occurs at a multiplicity of discharge initiation points (6) on the contour (3).

17. Counter electrode (10) according to Claim 16, wherein the surface structure (2) comprises a multiplicity of surface structure segments (5), wherein gaps are arranged between the surface structure segments (5), and wherein the gaps, together with the surface structure segments (5), form the surface structure (2).

18. Device (100) having a counter electrode (1) according to Claim 16 or 17 and a piezoelectric transformer (1), wherein the device (100) is configured to discharge the gas between the surface structure (2) and the piezoelectric transformer (1).

19. Device (100) according to Claim 18, wherein the piezoelectric transformer (1) is arranged at least in part within a cavity formed by the counter electrode (10).

20. Device (100) according to either of Claims 18 and 19, wherein the piezoelectric transformer is a transformer according to one of Claims 1 to 14.

## Revendications

1. Transformateur piézoélectrique (1) doté d'une structure superficielle (2), dans un espace intermédiaire entre le transformateur piézoélectrique (1) et une contre-électrode (10) étant placé un gaz, le transformateur piézoélectrique (1) présentant un contour (3) et étant apte, en coopération avec la contre-électrode (10) à décharger le gaz pour générer un plasma, la structure superficielle étant conçue de telle sorte que la décharge de gaz soit initiée sur une pluralité de points d'initiation de la décharge (6) sur le contour (3), la largeur (B1) d'un segment de structure superficielle (5) de la structure superficielle (2) étant inférieure à la largeur (B) du transformateur piézoélectrique (1) et la structure superficielle (2) ayant une forme polygonale et comportant une pluralité de segments de structure superficielle (5) et **caractérisé en ce que** la structure superficielle comporte au moins un segment de structure superficielle (5) débordant.

2. Transformateur piézoélectrique (1) selon la revendication 1, le segment de structure superficielle (5) définissant le contour (3) du transformateur piézoélectrique (1).

3. Transformateur piézoélectrique (1) selon la revendication 1 ou 2, la largeur (B1) du segment de structure superficielle étant supérieure à 10 µm.

4. Transformateur piézoélectrique (1) selon au moins l'une quelconque des revendications précédentes, la structure superficielle s'étendant d'entre 2 mm et 4 cm au-delà de la largeur (B1) du transformateur piézoélectrique (1).

5. Transformateur piézoélectrique (1) selon au moins l'une quelconque des revendications précédentes, la structure superficielle (2) comportant une pluralité de segments de structure superficielle (5), entre des segments de structure superficielle (5) voisins étant placé chaque fois un espace intermédiaire et ensemble avec l'espace intermédiaire, les segments de structure superficielle (5) formant la structure superficielle (2).

6. Transformateur piézoélectrique (1) selon la revendication 5, la structure superficielle (2) comportant un profil superficiel, et la profondeur de profil (H) du profil superficiel (4) de la structure superficielle (2) étant supérieure à la largeur (B1) d'un segment de structure superficielle (5) .

7. Transformateur piézoélectrique (1) selon la revendication 5 ou 6, les points d'initiation de la décharge (6) se situant dans un plan, et dans la section transversale, les segments de structure superficielle étant triangulaires, carrés, par exemple rectangulaires et comportant plus de quatre angles.

8. Transformateur piézoélectrique (1) selon au moins l'une quelconque des revendications 1 à 4, le segment de structure superficielle (5) respectif étant déterminé par la partie droite d'un tracé polygonal, et les points d'initiation de la décharge (6) se situant dans différents plans.

9. Transformateur piézoélectrique (1) selon la revendication 1 à 4, la structure superficielle (2) ne comportant qu'un unique segment de structure superficielle (5), qui sur le côté sortie du transformateur piézoélectrique (1) définit une surface terminale de celui-ci et les points d'initiation de la décharge (6) se situant dans le même plan.

10. Transformateur piézoélectrique (1) selon au moins l'une quelconque des revendications précédentes, lequel se rétrécit vers un côté sortie du transformateur piézoélectrique (1}.

11. Transformateur piézoélectrique (1) selon au moins l'une quelconque des revendications précédentes, le transformateur piézoélectrique (1) comportant un corps de transformateur qui est muni d'une pièce structurelle (20), la structure superficielle (2) étant conçue dans la pièce structurelle (20), et la pièce structurelle (20) étant fixement assemblée avec le corps de transformateur.

12. Transformateur piézoélectrique (1) selon au moins l'une quelconque des revendications précédentes, la die structure superficielle (2) étant conductrice électrique.

13. Transformateur piézoélectrique (1) selon au moins l'une quelconque des revendications 1 à 11, la structure superficielle (2) étant électriquement isolante, et la décharge de gaz étant une décharge à barrière diélectrique.

14. Transformateur piézoélectrique (1) selon au moins l'une quelconque des revendications précédentes, le contour (3), lequel est défini par les segments de structure superficielle (5) s'écoulant en forme de demi-cercle.

15. Dispositif (100) doté d'un transformateur piézoélectrique (1) selon au moins l'une quelconque des revendications précédentes, le dispositif (100) comportant une contre-électrode (10) qui est placée en faisant face à la structure superficielle (2) et la contre-électrode (10) étant conçue en étant planaire.

16. Contre-électrode (10) comportant une structure superficielle (2), qui comporte au moins un segment de structure superficielle (5) débordant, la contre-électrode (10) pouvant être assemblée avec un transformateur piézoélectrique, de telle sorte que dans un espace intermédiaire entre la contre-électrode (10) et le transformateur piézoélectrique soit placé un gaz, la contre-électrode (10) présentant un contour (3) et étant apte, en coopération avec le transformateur piézoélectrique (1) à décharger le gaz, pour générer un plasma, la décharge de gaz étant initiée sur une pluralité de points d'initiation de la décharge (6) sur le contour (3).

17. Contre-électrode (10) selon la revendication 16, la structure superficielle (2) comportant une pluralité de segments de structure superficielle (5), entre les segments de structure superficielle (5) étant placés des espaces intermédiaires, et ensemble avec les segments de structure superficielle (5), les espaces intermédiaires formant la structure superficielle (2).

18. Dispositif, (100) doté d'une contre-électrode (1) selon la revendication 16 ou 17 et d'un transformateur piézoélectrique (1), le dispositif (100) étant conçu pour décharger le gaz entre la structure superficielle (2) et le transformateur piézoélectrique (1).

19. Dispositif (100) selon la revendication 18, le transformateur piézoélectrique (1) étant placé au moins en partie à l'intérieur d'une cavité creuse formée par la contre-électrode (10).

20. Dispositif (100) selon l'une quelconque des revendications 18 ou 19, le transformateur piézoélectrique étant un transformateur selon l'une quelconque des revendications 1 à 14.
